# EUROPEAN PATENT APPLICATION

(11) **EP 3 890 008 A1**
(43) Date of publication of application: **06.10.2021**
(21) Application number: 20315090.9
(22) Date of filing: 31.03.2020
(51) Int. Cl.: H01L 23/488, H01L 21/60

(54) **SEMICONDUCTOR MODULE ASSEMBLY COMPRISING A JOINT LAYER WITH AN ELASTIC GRID BETWEEN A SEMICONDUCTOR DIE AND A SUBSTRATE AND MANUFACTURING PROCESS OF SUCH ASSEMBLY**

(71) Applicant: Mitsubishi Electric R&D Centre Europe B.V., 1119 NS Schiphol Rijk Amsterdam (NL); Mitsubishi Electric Corporation, Tokyo 100-8310 (JP)
(72) Inventor: Brandelero, Julio, 35708 Rennes Cedex 7 (FR); Voyer, Nicolas, 35708 Rennes Cedex 7 (FR)
(74) Representative: Plasseraud IP

(57) **Abstract**

A power module assembly comprises a power die (5) attached to a substrate (1) through a joint layer (41) comprising solid pads (4, 4') of metal alloy material connecting electrically and thermally said power die (5) to said substrate (1), wherein said solid pads (4, 4') are located within cells (200, 201, 202) of a grid (2, 2') made of an elastic material and having cell walls (20) extending between the surface of the substrate (1) and the surface of the die (5) facing each other. A process for manufacturing the power module assembly comprises: providing an elastic grid (2, 2') having a length and a width corresponding to the length and width of the semiconductor die (5) to attach; placing and attaching said elastic grid (2, 2') on the substrate (1); placing a stencil (3) forming a frame with a shape adapted to a contour of the semiconductor die (5) on the substrate (1) around the grid (2, 2') and applying paste (9) with a screen printing technique in the area defined by the stencil (3); removing the stencil (3); placing the power semiconductor die (5) on top of the paste (9); applying pressure on the die (5) to compress the assembly made of the die (5), the grid (2, 2') and paste (9) and the substrate (1); heating (10) the assembly either to melt the metal particles of the paste (9) or to sinter the particles; and cooling the assembly to provide solid pads (4, 4') embedded in said grid (2, 2'). The grid (2, 2') acts as an elastic barrier, preventing crack propagation within the joint layer (41) while providing little thermal resistance. The grid (2, 2') may be a honeycomb shaped (2) or square shaped (2') lattice. A grid cell (200, 201, 202) size may be at least ten times bigger than a grid wall (20) width. The width of walls (20) of the grid cells (200, 201, 202) may be larger than half of the thickness of the joint layer (41). The grid material may be such that the walls (20) of the grid (2, 2') contract with an increase of temperature, helping applying a high pressure on the paste (9) during the heating process phase and allowing the solid paste (4, 4') to expand in the hot areas without extra constraint during the operation of the power semiconductor die (5), leaving room to the rest of the joint layer (41) to expand under high temperature, relaxing the stress. The grid (2, 2') may be a polyimide grid, in particular, made out of a single- or double-faced adhesive polyimide tape. The grid (2') may comprise peripheral cells (201) of a reduced width with respect to central cells (202) of the grid (2'), limiting propagation of cracks so that the cracks cannot grow from the sides or corners more than the width of the reduced width cells (201) while inner cells (202) may be larger to reduce the degradation of the overall thermal resistance. The cells (200, 201, 202) of the grid (2, 2') may be shaped through laser cutting. The elastic grid (2, 2') may be formed as a tape with adhesive on both sides and be glued on both the substrate (1) and the die (5). The elastic grid (2, 2') may be placed and attached on the substrate (1) with a screen printing technique using an ink charged with high thermal conductive particles.

## Description

### Field of the invention

The present disclosure concerns a semiconductor module assembly comprising an improved joint layer between a semiconductor die and a substrate and a manufacturing process for such a semiconductor module assembly.

### Background

Power semiconductor modules usually comprise one or more power semiconductor module assemblies comprising a die or dies attached to a substrate or substrates with a joint layer.

The power semiconductor dies need to be connected to external circuits by the both faces. Current die attach techniques with such interconnections are based on soldering and/or sintering. On one face, a classical soldering/sintering process is used to connect the die/die to a lead frame or DBC (Direct Bonded Copper) substrate. This connection is commonly called a die attach. In this process, a paste including metal particles is deposed on the substrate, heated until melting or sintering and solidified during cooling down. The other face of the die is normally connected through wire bonding or direct copper connections.

In such modules, lifetime is mostly controlled by the package interconnections.

Increase of the reliability of these interconnections is given by improvements in the composition of the paste, a better control of the process of the paste deposition during the assembling process and adapted package design to reduce thermal/mechanical stress and deformations taking into account the environmental stresses.

### Problem addressed by the invention

In a classical power module, the power die is attached mechanically to a substrate that usually contains a metallic layer. This connection, called die attach, formed by a joint layer, ensures the electrical connection of a drain pad in a case of a Mosfet, a collector pad in a case of an IGBT, a cathode pad in a case of a diode to the external pinout of the power module. Furthermore, the heat created by the semiconductor is dissipated through this connection. This connection is formed with a joint using a paste that contains powder of metals and additives. In the process of assembling the module, the paste is deposed on the substrate layer, with a thickness inferior to 200µm, then the die is positioned on the paste layer and temperature and some pressure is applied to the structure in order to melt or sinter the paste and finally the paste is cooled and solidifies to form the joint layer. As known in the art, the paste has a melting point higher than the temperature of operation of the power semiconductor so that the joint does remains solid during operation of the semiconductor.

One of the main causes of power module failure is the deterioration of the joint layer. During the lifetime of the power modules, the joint layer ensures an electrical and thermal connection of the die to the external environment. Then, this interface is placed between two materials with different coefficient of thermal expansion (CTE), one being a semiconductor, e.g. Si (with a linear CTE of 2.56e-6/K) and other being a metal, e.g. Cu (with a linear CTE of 17e-6/K).

During operation of power modules, the temperature swings induces different expansion on the materials causing thermal/mechanical stress and consequently a fatigue mechanism takes place. Given this stress, cracks occur in the joint layer. The cracks grow with time creating voids on the layer. Furthermore, a local fragility is created when two voids are close to one another and facilitates crack propagation between these voids. One of the consequences of this deterioration is the increase of the thermal/electrical resistance of the joint, which consequently increases the temperature and accelerate even more the degradation process.

To summarize, the temperature swings create thermal/mechanical stress on the structure made of the die, the joint layer and the substrate that lead to formation and propagation of cracks in the joint layer that limits the lifetime of the power module.

### Summary of the invention

In view of the above problem and in view of the requirements on power conversion systems which include long lifetime and high resistance to degradation, the present invention aims to limit propagation of cracks in the joint layer an therefore proposes a power module assembly comprising a power die attached to a substrate through a joint layer comprising solid pads of metal alloy material connecting electrically and thermally said power die to said substrate, wherein said pads are located within cells of a grid made of an elastic material and having cell walls extending between the surface of the substrate and the surface of the die facing each other. Such a grid prevents crack propagation within the joint layer while providing little thermal resistance.

In preferred embodiments, the grid may be a honeycomb shaped or square shaped lattice.

In embodiments which may be combined or alternate:
The grid cell size may be at least ten times bigger than a grid wall width. This is a good compromise between the thermal resistance and the crack propagation;
The width of walls of the grid cells may be larger than half of the thickness of the joint layer. This ensures a good strength of the grid;
A maximum width of the cells of the grid may be below micrometers and preferably below 600 micrometers. This also limits propagation of cracks while limiting thermal resistance;
The grid may have a thickness between 20 micrometers and 100 micrometers. This is in correspondence with usual joint layers height which permits to remain in the usual components dimensions while limiting the thermal resistance;
The grid material may be such that the walls of the grid contract with an increase of temperature. This permits expansion of the joint layer material;
The grid may be a polyimide grid. Such material provides easy handling and retracts when temperature increases;
The grid may be made out of a single or double faced adhesive polyimide tape which simplifies the process by keeping the grid still;
The grid may comprise peripheral cells of a reduced width with respect to central cells of the grid. Such an arrangement improves crack stoppage in the periphery of the joint layer where such cracks have a higher probability to occur;
The present disclosure also concerns a process for manufacturing a power module assembly as disclosed above comprising:
   - providing an elastic grid having a length and a width corresponding to the length and width of the semiconductor die to attach;
   - placing and attaching said elastic grid on the substrate;
   - placing a stencil (3) forming a frame with a shape adapted to a contour of the semiconductor die on the substrate around the grid and applying paste with a screen printing technique in the area defined by the stencil;
   - removing the stencil;
   - placing the power semiconductor die on top of the paste;
   - applying pressure on the die to compress the assembly made of the die, the grid and paste and the substrate;
   - heating the assembly up to the melting point of the paste;
   - cooling the assembly to provide solid pads embedded in said grid.

In embodiments of the process which may be alternate or combined:
The cells of the grid may be shaped through laser cutting.

The elastic grid may be in formed as a tape with adhesive on both sides and be glued on both the substrate and the die;
The elastic grid may be placed and attached on the substrate with a screen printing technique using an ink charged with high thermal conductive particles. The assembly of the present disclosure may be used to manufacture a power module in which the die is connected mechanically and electrically to the substrate.

### Brief description of the drawings

A detailed description of exemplary embodiments of the invention will be discussed hereunder in reference to the attached drawings where:
Figure 1 represents a prior art joint with cracks between a substrate and a die viewed from a side;
Figure 2 represents a prior art joint with crack viewed from above;
Figure 3 represents manufacturing steps of a device of the present disclosure in perspective view;
Figure 4A and 4B represent respectively a perspective view of an example of a first embodiment of a grid of the present disclosure and a schematic side cut view of a device with a grid such as in figure 4A;
Figure 4C represents another embodiment of a grid with square cells of different size;
Figures 5A and 5B represent schematic side cut views of a prior art joint respectively under low and high temperature;
Figures 6A and 6B represent schematic side cut views of the joint of the present disclosure respectively under low and high temperature;
Figure 7 represents a power module using a device of the present disclosure.

### Detailed description of embodiments of the invention

The present disclosure concerns a power module assembly which comprises a power semiconductor die or chip, a substrate such as a stack of ceramic and copper on which the die or dies are to be mechanically attached and electrically and thermally connected and a joint layer comprising paste, which is solidified through a heating and cooling process to attach said die to said stack.

Such power modules assemblies can be used in power modules such as IGBT modules e.g. IGBT Modules S1 series of the company Mitsubishi Electric

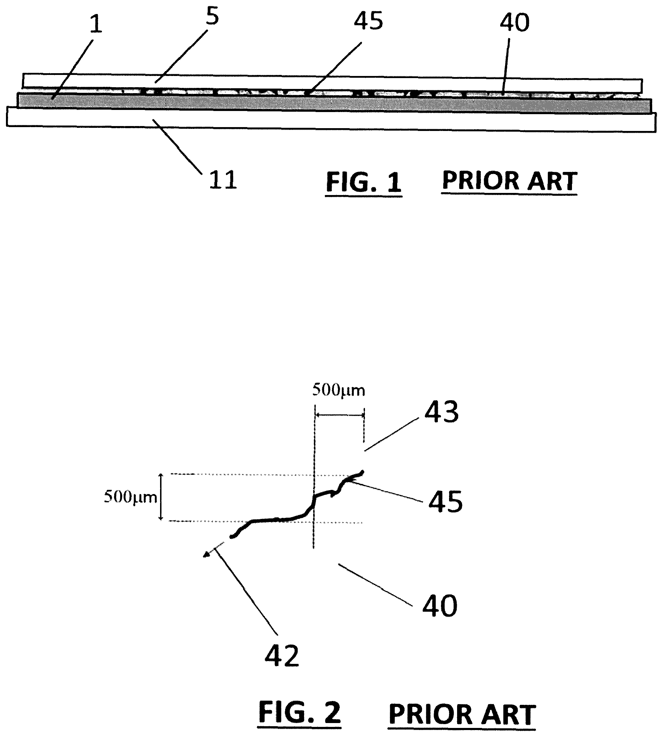

A schematic example of prior art power module assembly with attachment of a die 5 to a substrate through a prior art joint layer 40 is given in figure 1. Such attachment may be the object of cracks while ageing, as represented in figures 1 and 2.

Figure 1 provides a side view of a prior art assembly of a die 5 on a substrate 1 such as a copper layer which is itself attached to a base plate 11 e.g. a ceramic electrically insulating layer to form a stack as said here above. The die 5 is attached to the substrate 1 through the joint layer 40 where after time several cracks 45 start from a side of the joint layer. In figure 2 viewed from above a crack 45 initiated at a corner 43 of the joint layer propagates itself in a direction 42 along a diagonal and as time goes on has its length increasing above millimeters.

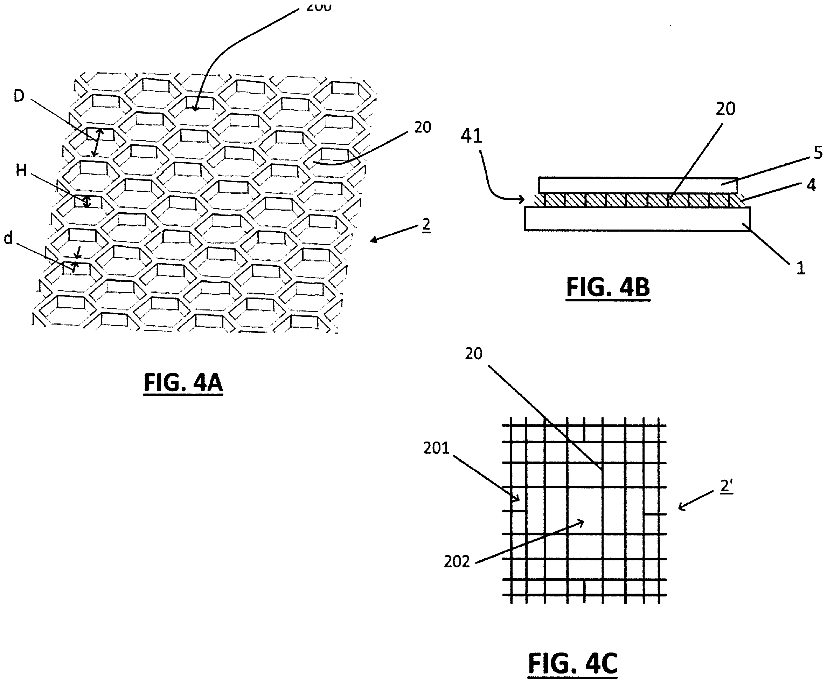

In order to limit expansion of such cracks the present disclosure proposes to incorporate a grid such as represented in figure 4A and made with an elastic material. The grid is in the form of a lattice having cells open in a direction perpendicular to the faces to be joined of the substrate and die.

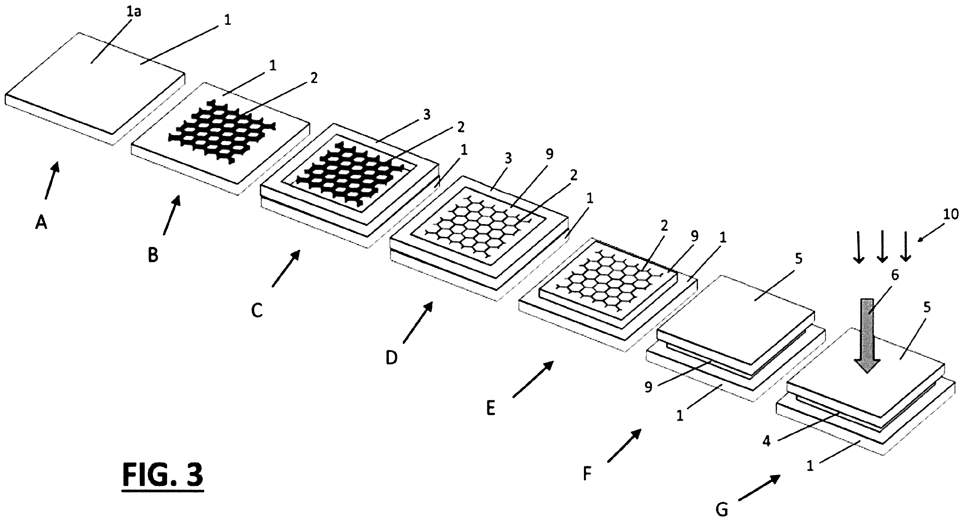

In step D of figure 3 paste 9 is deposited in the cells of the grid 2, between the walls 20 of such grid in order to fill such cells and attach the die 5 to the substrate 1 after solidification of the paste. Figure 4B shows the joint layer 41 with solidified paste pads 4 and cell walls 20 of a grid in lateral cut view.

The paste is usually an Ag paste or Cu paste or Sn based paste as known in the field of the invention and is a paste having particles of metal alloys and additives. When it is heated at a certain temperature, the paste becomes solid paste.

The grid placed in the joint layer limits the propagation of cracks in the joint layer by confining the cracks in the interior of the grid cells with the grid walls acting as an elastic barrier that stops the cracks.

As described hereunder, the die 5 is assembled with the substrate through the joint layer 41 made from paste 9 in the cells of the grid 2 and the assembly is heated either to melt the metal particles of the paste in a reflow process or to sinter the particle so that such paste solidifies to provide solid pads embedded in the grid cells when the assembly is cooled.

Once such structure is assembled, the die side remote from the substrate can be processed as in traditional power semiconductors manufacturing.

In the embodiment of figure 4A, the grid pattern may be a hexagonal pavement shape. Thus, an effective prevention of propagation of cracks starting from any point of the cell is obtained. Small grid wall width are achievable compared to other geometries, enabling limited reduction of thermal and electrical impedance of the joint layer, therefore limiting the increase of junction temperature of the semiconductor die, and extending its lifetime. A grid with a square pavement shape could also be used as described hereunder.

In figure 4A the grid 2 is formed as a lattice having hexagonal cells 200 separated by walls 20 and typically the cells maximum width is typically at least ten times bigger than the width of the walls separating the cells.

In a preferred embodiment, the width D of the grid cells 200 is defined as being at least 10 times larger than the width d of the grid walls, and the wall grid width is larger or equal than half the height H of the walls of the grid. Typical dimensions are about 500 µm to 1000 µm for the cell width D, 50 µm to 70 µm for the wall width d and 10 µm to 80 µm for the wall height H. In a specific embodiment D=700 µm, d=70 µm and H=25 µm with a tolerance of 20%.

Thus, the thermal resistance of the joint layer is increased by the presence of the grid in the joint layer at worse by less than 10%. This is small compared with the degradation of the thermal resistance during the lifetime of conventional power modules which is typically 30%.

In a specific embodiment as in figure 4C, peripheral grid cells 201 of a grid 2' may be smaller than 500 µm on the borders of the joint layer, e.g. on a few rows since cracks often start from the borders or the corners of the joint layer. Reducing the width of the cells at these positions is of interest to further limit propagation of crack especially with respect to horizontal cracks that often starts from the corners. In example, d=70µm, H= 25µm, a peripheral row and line of the grid may have 70 µm to 200 µm width cells while the rest of the cells 202 are 500 µm to 700 µm diameter/width cells or more. Preserving d=70µm and H= 25µm.

Thus, the cracks cannot grow from the sides or corners more than the width of the reduced width cells while inner cells may be larger to reduce the degradation of the overall thermal resistance. The area potentially affected by cracks is limited to a marginal portion of the die/substrate attach surface and the power module has better reliability and longer lifetime. Furthermore, the temperature of the die being smaller on the periphery of the die, the increase of the thermal resistance in this region helps to equalize the temperature over the die surface.

The grid material is chosen to provide the capability to contract with an increase of temperature. First this helps applying a high pressure on the paste during the heating process phase and second this allows the solid paste to expand in the hot areas without extra constraint during the operation of the power semiconductor die. Contracting of the elastic grid leaves room to the rest of the joint layer to expand under high temperature, relaxing the stress during the lifetime operation of the power modules. In consequence, cracks are less prone to nucleation and to propagation and the lifetime of the power module is improved.

It should be noted that contraction of the grid in the height H direction of the walls is not an issue as this would only provide voids with no consequence on the solidified paste joint.

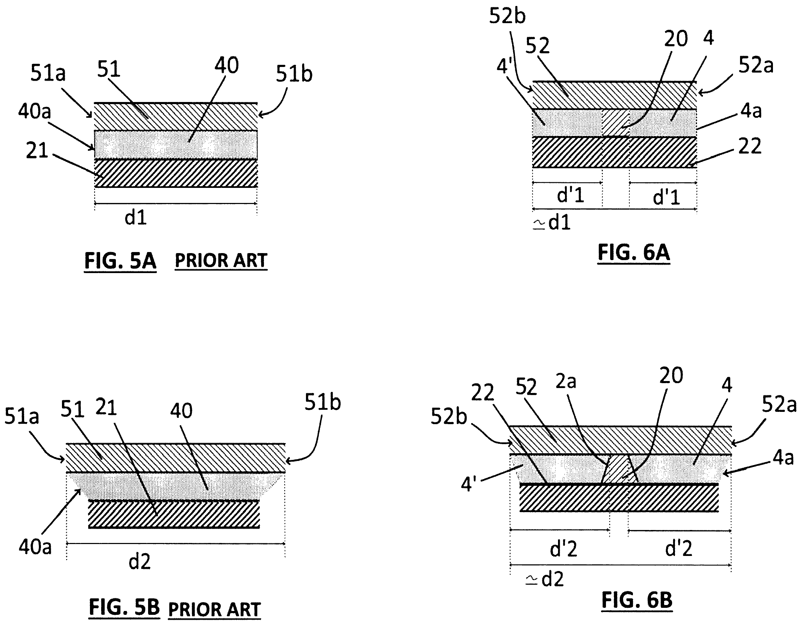

To illustrate the effect of temperature, an example of prior art design is given in figures 5A showing a segment with a length d1 where the assembly of the die 51, the joint layer 40a and the substrate 21 is at ambient temperature and figure 5B where such assembly is heated due to the losses created by the electrical power load applied to the power chip.

An example of a segment of a length close to d1 with two cells of the present grid design is given in figures 6A at ambient temperature and figure 6B under load. In this example one grid wall 20 is shown with two cells filled with solidified paste pads 4, 4' between the die segment 52 and the substrate segment 22.

While in figure 5A and 6A, the dies 51, 52 are at ambient temperature and have their nominal width, in figures 5B and 6B, the die 51, 52 expand at their extremities 51a, 52a since these are heated by the power dissipated when the component is under load. Since the substrates 21, 22 are cooler than the dies 51, 52; this causes a shear stress on the prior art joint layer layers 40 and on the solidified paste pads 4, 4'. In figure 5B, the joint layer is stressed at its extremities 40a by the total dilatation of d2-d1.

In figure 6b, the dilatation of the solidified paste pads 4 and 4' in 4a and 4'a is half the dilatation of the prior art layer 40 and in addition, the upper part 2a of the wall 2 contracts which reduces stress on the solidified paste pads 4, 4' in the cells. As this is repeated on the total length and width of the die, the total stress at the contour of the die is reduced according to the number of cells involved highly reducing the stress at the contour and corners of the die.

The elastic grid may be shaped to desired grid shape using laser cut or screen printing and a preferred material for the grid is polyimide or the reference Elpemer® 2467 or another polymer material that can withstand the reflow temperature of the paste and which has contracting capabilities.

The grid preferably has a 10-80 µm height that is a typical height of joint layers. The grid can also be colored to help its identification and placement during the manufacturing process. Lastly, the tape shaped grid offers uniform height, helping to unify the height of the joint layer.

The walls width may be bigger than half the thickness of the joint layer. This helps building the grid from a tape using laser cutting techniques of polyimide tapes or from an ink using a screen printing technics or the combination of the two processes and provides walls of a sufficient surface for effective adhesion to the substrate.

The process of manufacturing a power module assembly with a die connected mechanically and electrically to the substrate in accordance with the disclosure is shown in figure 3. Such process starts from a substrate 1 with a receiving surface 1a for a joint layer and a die shown at A and comprises:
- in step B placing and attaching the elastic grid 2 on the substrate layer;
- in step C placing a stencil 3 forming a frame with a shape corresponding to the semiconductor die contour or to the semiconductor die size on the substrate layer around the grid 2;
- in step D, applying paste 9 on the grid inside the stencil 3 inner contour;
- in step E removing the stencil;
- in step F placing the power semiconductor die 5 on the top of the paste 9;
- in step G applying pressure 6 on the die to compress the grid and the paste in the cells of the grid then or at the same time heating 10 the assembly up to the melting point or sintering temperature of the paste then the power module assembly is cooled to provide the solidified paste pads 4 of the joint layer.

In step C, the stencil may be shaped as to lie around the dimensions of the contour of the die or shaped to lie under the border of the contour dimensions of the die.

After this, the cooled and solid power module assembly is processed further to make a power module as in former modules.

Application of the paste at step D can be done with a screen printing technique.

During application of pressure on the die, the die and substrate are kept parallel to provide a homogeneous layer of paste 9 inside the cells of the grid without voids during the heating and cooling phases and to ensure that the thickness of the final joint layer is the same all along the die surface.

The grid may be formed from a tape where the cells holes are made with a laser cutting process. The tape is the cut to form a pad of the size of the die in order to be attached to the substrate. An Automatic labeler may place and attach the grid on the substrate.

The elastic grid may be formed, placed and attached on the substrate with a screen printing technique where ink is charged with high thermal conductive particles. Thus, the thermal resistance of the grid is reduced given the metallic particles.

In an alternate embodiment, the elastic grid may be provided with adhesive on one or its two sides to be glued to the substrate or to the substrate and die. This helps the grid not to move during the above described manufacturing process. The grid could be provided in the form of a tape with adhesive on its two faces.

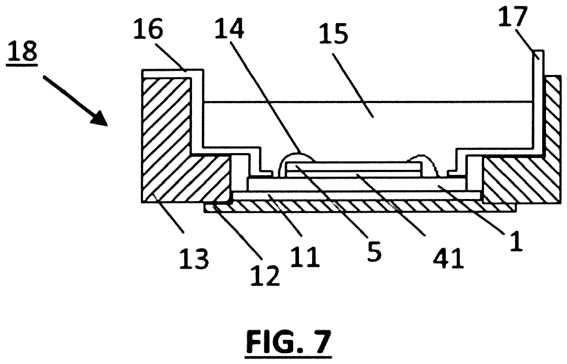

Once this process is done, the resulting assembly is used to manufacture a power component as an IGBT or other component according to the type of die used as for example shown in figure 7 where the component receiving the assembly made of the die 5, the joint layer 41 made in accordance with the present disclosure and the substrate composed by a stack of copper 1 and an electrically insulating but heat conductive layer 11 such as a ceramic layer, a heat conductive base plate 12, a housing 13, an encapsulating gel 15 and where the substrate comprises conductive lines for receiving wire bonds 14 for connecting tracks from the upper side of the die to contact elements 16, 17 that exit the power module.

The invention of the present disclosure is not limited to the example shown and in particular, more than one die may be received in a power module.

## Claims

**1.** Power module assembly comprising a power die (5) attached to a substrate (1) through a joint layer comprising solid pads (4) of metal alloy material connecting electrically and thermally said power die to said substrate, wherein said pads (4) are located within cells (200, 201, 202) of a grid (2, 2') made of an elastic material and having cell walls extending between the surface of the substrate (1) and the surface of the die (5) facing each other.

**2.** Power module assembly according to claim 1 wherein the grid (2, 2') is a honeycomb shaped (2) or square shaped (2') lattice.

**3.** Power module assembly according to claim 1 or 2, where a grid cell size is at least ten times bigger than a grid wall (20) width.

**5.** Power module assembly according to claim 1, 2 or 3 where the width of walls (20) of the grid cells (200) is larger than half of the thickness of the joint layer.

**5.** Power module assembly according to any one of the preceding claims, where a maximum width of the cells (200, 201, 202) of the grid is below 800 micrometers and preferably below 600 micrometers.

**6.** Power module assembly according to any one of the preceding claims where the grid (2, 2') has a thickness between 20 micrometers and 100 micrometers.

**7.** Power module assembly according to any one of the preceding claims where the grid material is such that the walls (20) of the grid contract (2a) with an increase of temperature.

**8.** Power module assembly according to any one of the preceding claims where the grid (2, 2') is a polyimide grid.

**9.** Power module assembly according to claim 8 where the grid (2, 2') is made out of a single or double faced adhesive polyimide tape.

**10.** Power module assembly according to any one of the preceding claims where the grid (2') comprises peripheral cells (201) of a reduced width with respect to central cells (202) of the grid.

**11.** Process for manufacturing a power module assembly according to any one of claims 1 to 10 comprising:
- providing an elastic grid (2) having a length and a width corresponding to the length and width of the semiconductor die (5) to attach;
- placing and attaching said elastic grid (2) on the substrate (1);
- placing a stencil (3) forming a frame with a shape adapted to a contour of the semiconductor die on the substrate around the grid (2) and applying paste (9) with a screen printing technique in the area defined by the stencil;
- removing the stencil (3);
- placing the power semiconductor die on top of the paste;
- applying pressure on the die to compress the assembly made of the die, the grid (2) and paste (9) and the substrate;
- heating (10) the assembly up to the melting point of the paste;
- cooling the assembly to provide solid pads (4) embedded in said grid (2).

**12.** Process according to claim 11 wherein the cells of the grid are shaped through laser cutting.

**13.** Process according to claim 11 or 12 wherein the elastic grid (2) is in formed as a tape with adhesive on both sides and be glued on both the substrate and the die.

**14.** Process according to claim 11 or 12 wherein the elastic grid is placed and attached on the substrate with a screen printing technique using an ink charged with high thermal conductive particles.

**15.** Power module comprising an assembly in which a die (5) is connected mechanically and electrically to a substrate (1) through the process of any one of claims 11 to 14.
